# EUROPEAN PATENT SPECIFICATION

(11) **EP 2 017 366 B1**
(45) Date of publication and mention of the grant of the patent: **17.10.2012**
(21) Application number: 08012598.2
(22) Date of filing: 11.07.2008
(51) Int. Cl.: C23C 14/02, C23C 14/06

(54) **A method for the manufacture of a hard material coating on a metal substrate and a coated substrate**
Verfahren zur Herstellung einer harten Beschichtung für ein Metallsubstrat und beschichtetes Substrat
Procédé de fabrication d'un revêtement de matériau dur sur un substrat métallique et un substrat revêtu

(30) Priority: 13.07.2007 GB 0713671; 02.01.2008 GB 0800022
(43) Date of publication of application: 21.01.2009
(73) Proprietor: Sheffield Hallam University, South Yorkshire S1 1WB (GB)
(72) Inventor: Hovsepian, Papken, E., Sheffield S2 5LZ (GB); Ehiasarian, Arutiun, P., Sheffield S2 5LZ (GB); Tietema, Roel, 5926 Venlo (NL); Strondl, Christian, 5913 Venlo (NL)
(74) Representative: Manitz, Finsterwald & Partner GbR

(56) References cited:
- EP-A- 0 459 137
- EP-A- 1 260 603
- DE-A1-102005 033 769
- EHIASARIAN A P ET AL: "Comparison of microstructure and mechanical properties of chromium nitride-based coatings deposited by high power impulse magnetron sputtering and by the combined steered cathodic arc/unbalanced magnetron technique" THIN SOLID FILMS, ELSEVIER-SEQUOIA S.A. LAUSANNE, CH, vol. 457, no. 2, 15 June 2004 (2004-06-15), pages 270-277, XP004507225 ISSN: 0040-6090
- LEMBKE M I ET AL: "SIGNIFICANCE OF Y AND CR IN TIALN HARD COATINGS FOR DRY HIGH SPEED CUTTING" SURFACE ENGINEERING, INSTITUT OF MATERIALS, LONDON, GB, vol. 17, no. 2, 1 January 2001 (2001-01-01), pages 153-158, XP008032308

## Description

The present invention relates to a method for the manufacture of a hard material coating on a substrate consisting of a metal, TiAl or Ni based alloys or a ceramic material which is, for example, electrically conductive, for example a substrate in the form of a coated tool, a machine component or a turbine blade and to a coated substrate per se.

There are a large number of proposals for the coating of machine tools with hard materials which make it possible to prolong the working life of the tools and/or to increase the cutting speed and the quality of the cut that is possible on a large variety of metal workpieces including relatively hard metals, tool steels, die materials, aerospace materials, steels of diverse kinds, titanium alloys, forgings and castings. Similarly there is a large number of proposals for coating automotive or aerospace components or components in energy systems in order to provide protection against environmental attack at high temperatures.

By way of example European patent 1260603 B1 describes and claims coatings deposited by a PVD (Physical Vapor Deposition) process, consisting of the nitrides TiN, ZrN, TiAIN, TiZrN, TiWN, TiNbN, TiTaN, TiBN or the carbonitrides TiCN, ZrCN, TiAICN, TiZrCN, TiVCN, TiNbCN, TiTaCN, TiBCN. Moreover, the European patent EP 1260603 B1 discloses that the coating can contain from 0.1 to 5 at% of the rare earth elements Sc, Y, La, Ci.

In addition, the said European patent also discloses coatings consisting of fine (nanoscale) multilayer films having a periodicity from 1 to 10 nm selected from the group comprising TiN/TiAIN, TiN/VN, TiN/NbN, TiN/TaN, TiN/ZrN, TiAlN/CrN, TiAlN/ZrN, TiAlN/VN, CrN/NbN, CrN/TaN, CrN/TiN, Cr/C, Ti/Ci, Zr/C, V/C, Nb/C and Ta/C.

This listing will be understood by the person skilled in the art to mean that the coating consists of alternate layers of the two materials separated by the oblique line in the above material pairings. Again, one of the individual layers listed for these layer pairings can contain 0.1 to 5 at% of the rare earths Sc, Y, La and Ci.

Further particulars of some of the above mentioned coatings can be found in the literature, for example in the publications by Lembke et al in "Sign-ficance of Y and Cr in TiAlN hard coatings for dry high speed cutting", Surface Engineering 17(2) pages 153-158 (2001) in which the coating material Cr has been implanted in the interface using an arc discharge technique and in the paper by P.Eh.Hovsepian, C. Reinhard and A.P. Ehiasarian entitled CrALYN/CrN superlattice coatings deposited by the combined high power impulse magnetron sputtering/unbalanced magnetron sputtering technique in Surface and Coatings Technology 2001 (2006) pages 4105-4110. This reference describes, amongst other things, the pretreatment of the metal substrate in the sense of a cleaning/ etching treatment by bombarding the substrate with Cr ions generated by the so-called HIPIMS technique (High Power Impulse Magnetron Sputtering). This technique is also described and claimed in the aforementioned European patent. More specifically, the European patent describes a PVD method for the coating of substrates wherein the coating takes place by means of cathode sputtering after a pretreatment. The substrate is pretreated in the vapour of a pulsed cathode sputtering process assisted by a magnetic field. A field arrangement in the manner of that of a magnetron cathode is used for the magnetic field assistance during the pretreatment and has a strength in the horizontal component in front of the target of 100 to 1500 Gauss. Moreover, the power density of the pulse discharge in the pretreatment is more than 1000 W/cm⁻². The power density preferably lies in the range from 2000 to 3000 W / cm⁻². The pulse duration lies between 10 and 1000 µs and the pulse interval amounts to between 0.2 ms and 1000 s. The pulse duration is preferably 50 µs and the pulse interval 20 ms. The average pulsed discharge current density is expediently smaller than 10 A/ cm⁻² and the local maximum pulsed discharge current density typically lies below 100 A/cm⁻². The pulses used typically have a peak voltage in the range from 0.5 to 2.5 kV and the pretreatment is usually done in an argon atmosphere in the pressure range from 10⁻⁵ to 10⁻¹ bar and especially 10⁻³ mbar. The negative bias voltages applied to the substrates to achieve etching effects and ion implantation during pretreatment are generally between 0.5 and 1.5 kV. The paper specifically discloses the pre-treatment/ion etching/ion implantation using Cr ions, but also discloses that the pretreatment can take place with targets of Cr, V, Ti, Zr, Mo, W, Nb or Ta in a non-reactive atmosphere such as Ne, Ar, Kr or Xe.

Hitherto, the pretreatment, etching and ion implantation of metallic substrates has been carried out by the so-called ABS process (which is a trademark of Hauzer Techno Coating BV) and is described in European patent 0459137 B1. That patent discloses the use of an arc discharge to generate ions for the pretreatment of the substrate and the subsequent use of a cathode sputtering process to deposit coatings on the pretreated etched substrate. The joint use of an arc vaporization process and a magnetron sputtering process in one and the same chamber, which is covered by European patent 0403552 B1, makes it particularly convenient to carry out the ABS process which has been extensively used.

With some materials which are used for the generation of coatings and which contain low melting point elements problems can however arise in the arc process due to the formation of small droplets which are deposited on the substrate during the pretreatment process and which disturb the otherwise smooth coating that would be obtained during the subsequent magnetron sputtering process. It has fortuitously been found that such problems with droplet formation do not occur when the HIPIMS technique is used for the pretreatment of the substrate surface.

As described in the above reference paper by P.Eh. Hovsepian et al in Surface and Coatings Technology 201 CrAlYN/CrN nanoscale multilayer/ superlattice coatings, especially those deposited after pretreatment of the substrate surface with a highly ionized Cr+ and Ar+ plasma generated from a HIPIMS discharge leads to a substrate surface which is clean, free of surface oxides, sharp and free of a macroparticle interface. This provides good conditions for local epitaxial growth over large surface areas, thus resulting in excellent coating adhesion.

Moreover, the last named paper explains that the presence of the yttrium in the superlattice coating leads to a significant reduction in the oxidation rate and suppresses the diffusion of substrate elements, such as Fe, into the coating. It is noted that the intention is not to avoid an oxide coating at all, since tools having an exposed surface layer containing Al₂O₃, which is a very hard material, can be extremely beneficial in use, in particular when the tools are exposed to very high thermal loads such as occurs at high cutting speeds, and in particular high cutting speeds during dry cutting.

In many high temperature applications the interdiffusion of substrate and coating elements is very common. If a nitride based coating such as TiN, CrN or TiAlN is used, then, at long term exposure at high temperatures, nitrogen very often diffuses into the substrate forming a nitride compound or compounds with the substrate elements. This usually is detrimental to the mechanical properties of the coated substrate leading to reduction of the fatigue strength of the base material in particular.

The object underlying the present invention is to provide a method of preparing a coated substrate and a coated substrate which have even better properties than the coatings described above, but which can nevertheless be used with a large variety of known coatings.

Thus, the method and the coated substrate in accordance with the invention should provide improved cutting properties, improved resistance to wear, improved protection against environmental attack at high temperatures and improved protection against diffusion of elements from the substrate into the applied coating and vice versa, particularly for cutting tools which are used at high temperatures and/ or at high cutting speeds and/or in a dry or wet state and for components of automotive engines, aircraft gas turbines or stationary gas turbines exposed to high temperatures.

In order to satisfy these objects there is provided, in accordance with the present invention, a method for the manufacture of a hard material coating on a substrate consisting of a metal or of a ceramic material, e.g. a coated tool for use in a machine tool, or components exposed to high temperature wherein, prior to the deposition of the hard protective material coating, the substrate is pretreated by simultaneous bombardment with ions of more than one element but always including at least one rare earth element thereby resulting in implantation of said ions into said substrate, where the concentration of the implanted elements into said substrate does not exceed 50 at %, preferably does not exceed 20 at % and in particular does not exceed 10 at % and wherein the concentration of rare earth atoms embedded in said interfacial layer is in the range of 0.1-10% and most preferably in the range of 0.1-1%.

Furthermore, there is provided a coated substrate made by the method. That is to say a coated substrate comprising a metal or metal alloy such as a high speed steel, a TiAl based alloy or an Ni based alloy or an electrically conductive ceramic material, the substrate having an interfacial layer to the coating produced by simultaneous bombardment with ions of more than one element but always including at least one rare earth element thereby resulting in implantation of said ions into said metal or metal alloy or in the electrically conductive ceramic material, where the concentration of the implanted elements into said substrate does not exceed 50 at % and wherein the concentration of rare earth atoms embedded in said interfacial layer is in the range of 0.1-10% and most preferably in the range of 0.1-1%.

It has namely been surprisingly found that the pretreatment, i.e. etching of a metal or electrically conductive ceramic substrate surface using metal ions of rare earth elements, such as Y, La, Ci or Sc, with resulting implantation of rare earth element ions into the substrate surface, surprisingly results in a much higher oxidation resistance for the coating. This is believed to be due to the high affinity of the rare earth elements to the oxygen, as well as to the strong adhesion of the stable oxide that may form to the substrate and to the segregation by thermal displacement of the implanted rare earth material at the substrate material grain boundaries which then block the paths for diffusion of oxygen into this material at elevated temperatures.

The simultaneous implantation of ions of at least one rare earth material together with other ions such as Cr, Ti and/or Al into a substrate during an etching pretreatment of the substrate prior to the deposition of other layer systems thereon is not known from any prior art of which the applicants are aware and has proved to be very advantageous, particularly when the ion implantation/etching is carried out using the HIPIMS technique. Rare earth elements tend to have a large atomic radius and high concentration thereof lead to the generation of extremely high compressive stresses which are disadvantageous. If implanted in large quantities in the coating interface these high stress values will compromise the adhesion of the coating. The use of the HIPIMS technique allows the generation of an ion flux of more than one type of material, as it is a sputtering process, and a low concentration of rare earth elements in the interface together with other elements can be achieved. The other elements are preferably those or at least some of those used in the actual coating system. It has been found that such co-implantation allsows particularly beneficial results to be achieved and allows the above recited objects and advantages to be satisfied and achieved.

Although these effects can be attributed to some degree to rare earth elements incorporated into the coating itself, the concept that the rare earth elements could be implanted during pretreatment into the coating substrate interface either alone or in combination with another material is a completely novel idea and has proved to be very beneficial because the coating substrate interface is a very important and vulnerable zone in a coating-substrate system. The finding that the oxidation resistance of this zone can be further enhanced by the implantation of rare earth elements into the substrate material during the etching stage of the coating production process and that this leads to a further overall improvement of the protective functions of the coatings at high temperatures must be regarded as very surprising.

At this stage it will be noted that prejudices exist against the use of rare earth materials in arc PVD processes because they tend to lead to unstable discharges when present in the evaporation targets. It seems that rare earth elements tend to react with the oxygen from the residual gas in the vacuum chamber and form oxide films on the target surface which can cause arc spot retention problems and can indeed also lead to complete extinction of the arc discharge. The evaporation targets which have hitherto been used containing rare earth elements are usually multicomponent alloys of titanium, chromium and aluminum. The presence of elements with a low melting point, such as Al, in the target presents the drawback of generation of large amount of droplet phase and therefore coating defects in arc evaporation process

It is particularly preferred, but not essential, for the pretreatment (etching/ion bombardment) to be carried out using the HIPIMS process because it has been found that this permits the generation of ions of the rare earth elements in droplet-free manner regardless of the precise composition of the target material. The droplet-free ion flux can be accelerated and implanted in the substrate by the application of high-bias voltages to the substrate resulting in the production of extremely sharp and defect-free interfaces. The interfaces that are modified in composition, in this particular case enriched by one or more rare earth elements, such as Y, Lanthanum, or cesium - optionally in combination with other elements such as Cr - provide much higher oxidation resistance to the coating.

Preferred embodiments of the method and of the coated substrate are set forth in the subordinate claims.

The invention will now be explained in more detail with reference to the accompanying drawings in which are shown:
- Fig. 1: a cross-section through a coated substrate showing the individual layers of the coating, and
- Fig. 2: a cross-section similar to that of Fig. 1 but showing an alternative coating in accordance with the invention,
- Fig. 3: a yet further drawing similar to Fig. 1 but showing a further alternative coating in accordance with the present invention,
- Fig. 4: a yet further drawing similar to Fig. 1 and showing another coating in accordance with the invention and
- Fig. 5: a further alternative embodiment.

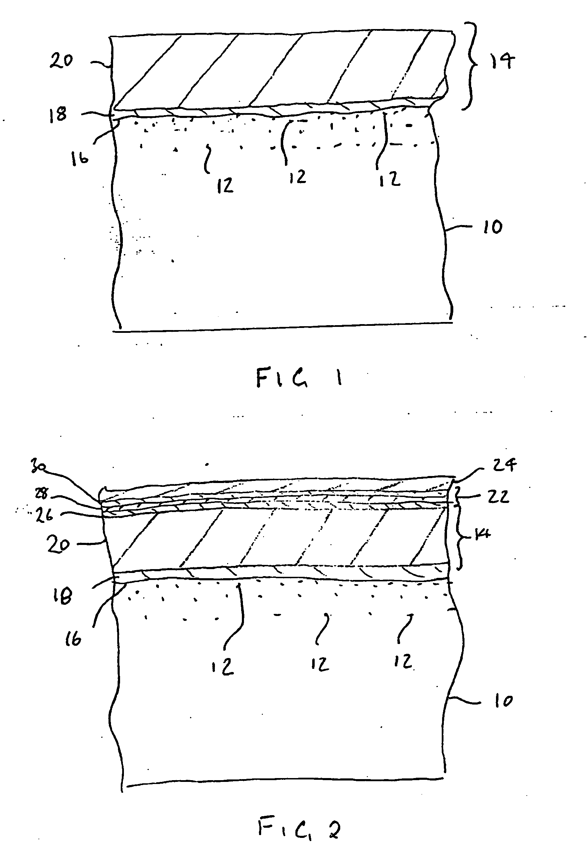

Fig. 1 shows a substrate in the form of a portion of a cemented carbide, a TiAl based alloy substrate or an Ni based alloy substrate 10 which has been pretreated by cleaning, etching and ion bombardment with yttrium ions in combination with Cr ions, or Cr and Al ions, or Ti ions or Ti and Al ions, resulting in yttrium and Cr and/or Al atoms or Ti and/or Al ions-such as 12 being incorporated to a depth of several nanometers in the surface of the substrate material adjacent to the coating 14 provided thereon.

Within 5 nm of the interface, the concentration of the rare earth element should preferably be in the range from 0.1 at% to 10 at%, preferably 0.1 to 1.0% and the concentration of the other ions, i.e. of Cr, or Cr and Al, or Ti or Ti and Al, is generally higher but the total concentration of the implanted ions should not exceed 50 at %, and should preferably not exceed 10 at 5 and especially not exceed 10 at %. The depth of the implanted zone can be as large as 100 nm.

There is a base layer 18 of TiAICrN on the substrate 10 at the interface 16 and, on top of this base layer 18, there is a layer 20 of TiAICrYN with an yttrium content of 1 at%.

The base layer 18 and the layer 20 are deposited using the apparatus, targets and parameters described in the above mentioned article by Lembke et al, Surface Engineering 2001, Vol 17, no. 2 pages 153-158. The yttrium ions 12 can be generated by an arc process from a target consisting of CrY, or of CrAlY, or of TiY or of TiAlY (for example) and this means that there are also some atoms of Cr, Cr and Al, Ti and Ti and Al incorporated during the surface cleaning and etching step to a depth of several nanometers in the surface layer of the substrate 10 adjacent the interface 16, which are not, however, shown here. Alternatively, the yttrium can be supplied from a heated vapor source with the plasma in the vicinity of the substrate being generated in the PVD apparatus by any known plasma generating process. A relatively high substrate bias of typically 1200 V can be used to ensure ion bombardment of the substrate with the yttrium ions.

Fig. 2 shows an alternative embodiment in which the substrate 10 is again a cemented carbide such as a tungsten carbide, a TiAl based alloy or an Ni based alloy where yttrium ions 12 are again implanted in the surface of the substrate 10 to a depth of several nanometers as shown in Fig. 1. In fact, the layers 18 and 20 are also the same as the layers 18 and 20 in the embodiment of Fig. 1 and the difference between the embodiment of Fig. 2 and the embodiment of Fig. 1 lies essentially only in the fact that the layer 20 is then covered by an interlayer system 22 and an overcoat layer 24. The interlayer system 22 comprises the same interlayer system as is described in the above mentioned article in Surface Engineering 2001 and comprises a superlattice structure of TiAlYN and CrN layers. It is also deposited in the same way. More specifically, the layers 26 and 30 consist in this example of CrN and the layer 28 of TilAlYN. It should however be noted that there are typically not just three layers as shown but rather a large number of relatively thin alternating layers of CrN and TiAlYN. Finally, the top layer 24 is a composite layer containing Ti, Al, Cr, O and N. The way these layers are produced is described in the Surface Engineering article referred to above and does therefore not need to be repeated here.

Instead of using the cemented carbide material as the substrate, it is also possible to use TiAl or Ni based alloys or a steel, such as a tool steel or any other suitable material for a high speed machining tool, or stainless steel e.g. suitable for machine components.,.

It has been found that the incorporation of the rare earth element yttrium together with ions of Cr, or Cr and Al, or Ti or Ti and Al to a depth of several nanometers into the substrate 10 immediately adjacent the interface 16 has a beneficial effect on the properties of the tool as described above and also provides better protection of TiAl or Ni based alloys against environmental attack.

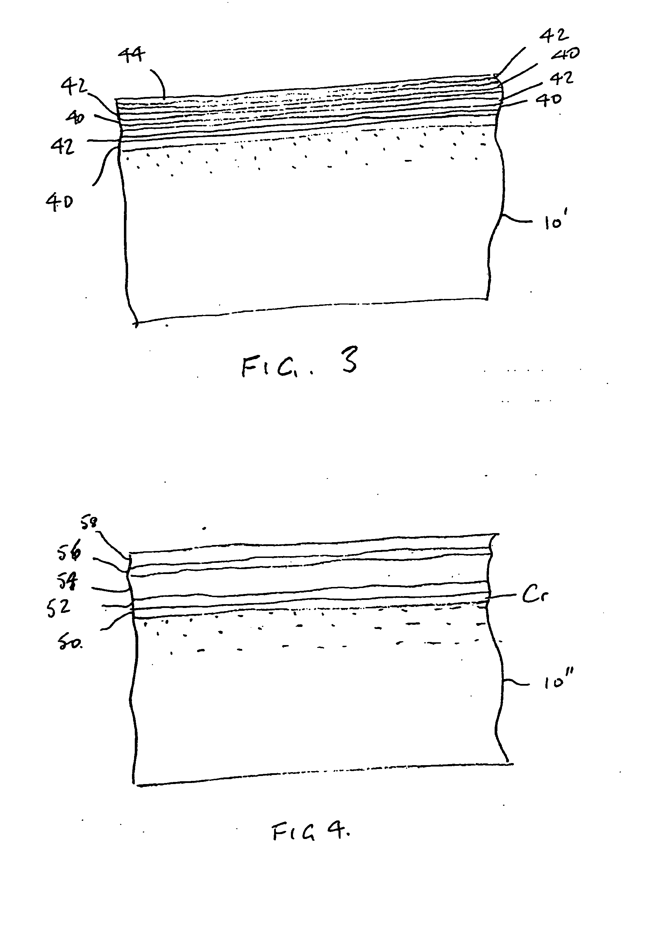

Fig. 3 shows an alternative embodiment. In this case the substrate is a stainless steel substrate 10' but could also be a cemented carbide substrate or any other tool material suitable for high speed machining, typically a metal substrate. The dots 12 again represent yttrium atoms and atoms of Cr, or Cr and Al, or Ti or Ti and Al incorporated in the surface layer of the substrate by ion bombardment during the surface cleaning and etching step. Again the concentration of the yttrium ions decreases from the interface 16 with progressive depth into the substrate. The concentration of the yttrium and the other co-deposited ions is the same as was suggested above in connection with Figs. 1 and 2.

A difference in this example is that the yttrium ions are generated in this embodiment by use of the HIPIMS technique from a target containing yttrium. More specifically the target can be CrY, CrAlY, TiY or TiAlY or any of the foregoing materials in which another rare earth elements is substituted for some or all of the yttrium.

On top of the substrate there is in this case a superlattice structure composing alternating layers 40 and 42 of CrAlYN/CrN deposited using the apparatus and the process, parameters and targets described by P.Eh. Hovsepian et al in Surface and Coatings Technology 201 2006 4105-4100, i.e. using the HIPIMS process. This superlattice structure is terminated by a further layer 44 consisting, in this example, of a graded layer 44 in which a layer of Al₂O₃ and Cr₂O₃ of about 350nm thickness gradually merges (i.e. with graded composition) into a layer of Al₂O₃ of about 175 nm thickness.

Again, the conditions for the deposition of the layer system 40, 42, 44 are the same as recited above in the article in Surface and Coating Technology 201 and will not therefore be repeated here.

Fig. 4 again shows a substrate 10", in this case of a 58 HRC hardened tool steel which has been pretreated by an arc process or preferably by HIPIMS to ensure precleaning and ion etching, with yttrium ions again being incorporated in the surface layer of the substrate close to the interface 16 to the actual hard material coating.

On top of the substrate 10" there is provided, above the interface 16, a hard material coating consisting of a Cr layer which has been deposited by an arc process in which some of the Cr ions are implanted into the surface region of the substrate 10" together with the yttrium ions. Above the Cr layer 50 there is then a base layer 52 of TiAIN followed by a layer 54 of TiAlYN, a CrN layer and finally an Al₂O₃ top oxide layer. As is usual, the nitrogen in the layers 52, 54 and 56 is supplied by a nitrogen atmosphere in the PVD coating chamber whereas the other layers are produced from targets of the corresponding materials, i.e. from a Cr target, from a TiAlY target, and from a TiAl target. The aluminium oxide top layer can either be produced from an Al₂O₃ target or simply from an Al target, which results in an Al₂O₃ oxide layer in a reactive process.

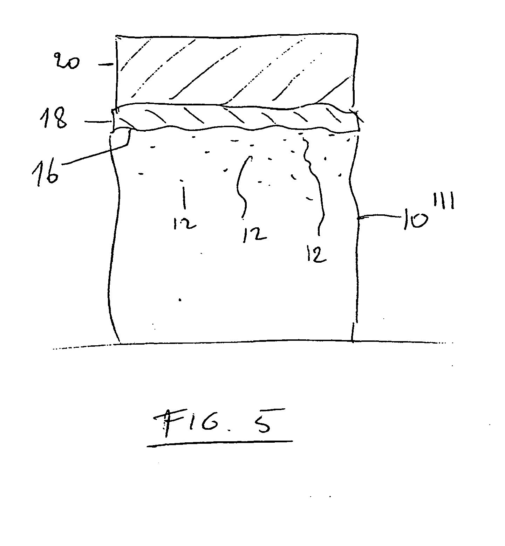

Finally, Fig. 5 shows an alternative embodiment. In this case the substrate is a stainless steel substrate, a TiAl based alloy or an Ni based alloy 10"', materials typically used for production of turbine blades, or automotive parts such as valves or piston rings.

The dots 12 again represent yttrium atoms and ions of other elements, for example as recited above incorporated in the surface layer of the substrate by ion bombardment during the surface cleaning and etching step. Again the concentration of the yttrium ions decreases from the interface 16 with progressive depth into the substrate. The concentration of yttrium is the same as was suggested above in connection with Figs. 1 and 2.

The yttrium ions in this embodiment are generated in the PVD apparatus by any known plasma generating process including the HIPIMS technique from a target containing yttrium.

In fact, the layers 18 and 20 are also the same as the layers 18 and 20 in the embodiment of Fig. 1 and the difference between the embodiment of Fig. 5 and the embodiment of Fig. 1 lies essentially only in the fact that the base layer 18 is s nitrogen free intermetallic layer or a nitrogen free PVD layer with a chemical composition similar to the one of the base material. The base layer can be deposited by any known metal vapor generating process in vacuum including the HIPIMS technique.

In all the examples given, other rare earth metals can be substituted for the yttrium, for example Sc La or Ce.

Moreover, the-coatings shown in the examples of Figs. 1 to 4 are but a few examples of possible coatings. The coatings named in connection with EP 1260603 B 1 in the introduction to this specification can also be used as can a whole variety of further tool coatings or coatings providing protection to components exposed to high temperatures known per se in the prior art.

The incorporation of ions of one or more rare earth elements into the surface layer of the substrate especially together with ions of other elements is so effective that it is not always necessary to incorporate one or more rare earth elements into the actual hard material coating, although this is frequently necessary or helpful in order to obtain the best possible results.

It should also be noted that any of the layers described can be deposited with graded transitions to the next adjacent layer by suitable control of the PVD process and the reactive gases supplied to the vacuum treatment chamber.

## Claims

1. A method for the manufacture of a hard material protective coating on a substrate consisting of a metal or of a ceramic material, e.g. a coated tool for use in a machine tool, or components exposed to high temperature wherein, prior to the deposition of the hard protective material coating, the substrate is pretreated by simultaneous bombardment with ions of more than one element but always including at least one rare earth element thereby resulting in implantation of said ions into said substrate to form an interfacial layer, wherein the concentration of the implanted elements into said substrate does not exceed 50 at %, preferably does not exceed 20 at % and in particular does not exceed 10 at % and wherein the concentration of rare earth atoms embedded in said interfacial layer is in the range of 0.1-10% and most preferably in the range of 0.1-1%.

2. A method in accordance with claim 1 wherein the rare earth material is at least one of yttrium Y, lanthanum La or cesium Ce or scandium Sc.

3. A method in accordance with claim 1 or claim 2, wherein the hard material protective coating is selected from the group comprising intermetallic PVD coatings such as TiAl, CrAl, AlSi, CrAlSi, nitride PVD coatings such as TiAlN, CrAlN, CrAISiN, intermetallic PVD coatings containing a proportion of one or more rare earth elements such as TiAl CrY, CrAlY, CrAlSiY, TiAlSiY nitride PVD-coatings containing a proportion of one or more rare earth elements such as TiAlCrYN, CrAlYN, CrAlSiYN, TiAlSiYN and multilayer PVD coatings comprising at least one rare earth element in one of the repeating layers such as CrAlYN/CrN, TiAlYN/CrN, CrAlN/CrYN.

4. A method in accordance with any one of the preceding claims wherein at least the substrate pretreatment step is carried out using metal ion implantation in which the rare earth metal ions are generated by a plasma discharge suited for the generation of metal ions or wherein the substrate pretreatment step is carried out using rare earth metal ions generated by a plasma discharge such as a HIPIMS (high power impulse magnetron sputtering) discharge, an arc discharge, and a filtered arc discharge and wherein a relatively high bias is preferably applied to the substrate during the substrate pretreatment step, e.g. a bias in the range from -500 to -1500 volts.

5. A method in accordance with any one of the preceding claims wherein the substrate coating is carried out in one or more steps selected from the group comprising HIPIMS coating, arc vaporization coating and magnetron sputtering.

6. A method in accordance with any one of the preceding claims wherein an oxide top coating or an oxynitride top coating (such as CrON) is provided, the top coating being preferably selected from the group comprising aluminium oxide, chromium oxide and silicon oxide and optionally containing at least one of yttrium Y, lanthanum La or cesium Ce or scandium Sc.

7. A method in accordance with any one of the preceding claims where an adjacent layer to the substrate base or transition layer is used which is a nitrogen free intermetallic layer and/or where an adjacent layer to the substrate base or transition layer is used which is nitrogen free with a chemical composition similar/identical to the one of the base material.

8. A method in accordance with any one of the preceding claims wherein the top coating is a nanoscale multilayer structure or a single layer nanocomposite structure or comprises a plurality of superimposed nanocomposite structures.

9. A coated substrate formed in accordance with any one of the above methods and wherein the concentration of rare earth atoms embedded in said interfacial layer is in the range of 0.1-10% and most preferably in the range of 0.1-1 %.

10. A coated substrate comprising a metal or metal alloy such as a high speed steel, a TiAl based alloy or an Ni based alloy or an electrically conductive ceramic material, the substrate having an interfacial layer to the coating produced by simultaneous bombardment with ions of more than one element but always including at least one rare earth element thereby resulting in implantation of said ions into said metal or metal alloy or in the electrically conductive ceramic material, where the concentration of the implanted elements into said substrate does not exceed 50 at % and wherein the concentration of rare earth atoms embedded in said interfacial layer is in the range of 0.1-10% and most preferably in the range of 0.1-1%.

11. A coated substrate in accordance with claim 10, wherein the coating comprises a hard material protective coating selected from the group comprising intermetallic PVD coatings such as TiAl, CrAl, AlSi, CrAlSi, nitride PVD coatings such as TiAIN, CrAlN, CrAISiN, intermetallic PVD coatings containing a proportion of one or more rare earth elements such as TiAlCrY, CrAlY, CrAlSiY, nitride PVD-coatings containing a proportion of one or more rare earth elements such as TiAlCrYN, CrAlYN, CrAlSiYN and multilayer PVD coatings comprising at least one rare earth element in one of the repeating layers such as CrAlYN/CrN, TiAlYN/CrN, CrAlN/CrYN.

12. A coated substrate in accordance with claim 10 or claim 11, wherein an oxide top coating or an oxynitride top coating (such as CrON) is provided, the top coating being preferably selected from the group comprising aluminium oxide, chromium oxide and silicon oxide and optionally containing at least one of yttrium Y, lanthanum La or cesium Ce or scandium Sc.

13. A coated substrate in accordance with any one of the claims 10 to 12, wherein an adjacent layer to the substrate base or transition layer is used which is a nitrogen free intermetallic layer and/or wherein an adjacent layer to the substrate base or transition layer is used which is nitrogen free with chemical composition similar to the one of the base material.

## Patentansprüche

1. Verfahren für die Herstellung einer Hartstoffschutzbeschichtung auf einem Substrat, das aus einem Metall oder einem Keramikwerkstoff besteht, z.B. einem beschichteten Werkzeug zur Verwendung in einer Werkzeugmaschine, oder Komponenten, die hoher Temperatur ausgesetzt sind, wobei vor der Abscheidung der Hartstoffschutzbeschichtung das Substrat durch gleichzeitige Bombardierung mit Ionen von mehr als einem Element, die aber immer zumindest ein Seltenerdenelement umfassen, vorbehandelt wird, wodurch sich eine Implantation der Ionen in dem Substrat ergibt, um eine Grenzflächenschicht zu bilden, wobei die Konzentration der implantierten Elemente in dem Substrat 50 Atom-% nicht übersteigt, bevorzugt 20 Atom-% nicht übersteigt und insbesondere 10 Atom-% nicht übersteigt, und wobei die Konzentration von Seltenerdenatomen, die in der Grenzflächenschicht eingebettet sind, im Bereich von 0,1 - 10 % und am stärksten bevorzugt im Bereich von 0,1 - 1 % liegt.

2. Verfahren nach Anspruch 1, wobei der Seltenerdenwerkstoff zumindest einer von Yttrium Y, Lanthan La oder Cäsium Ce oder Scandium Sc ist.

3. Verfahren nach Anspruch 1 oder 2, wobei die Hartstoffschutzbeschichtung aus der Gruppe ausgewählt wird, die intermetallische PVD-Beschichtungen, wie etwa TiAl, CrAl, AlSi, CrAlSi, Nitrid-PVD-Beschichtungen, wie etwa TiAlN, CrAlN, CrAlSiN, intermetallische PVD-Beschichtungen, die einen Anteil von einem oder mehreren Seltenerdenelementen enthalten, wie etwa TiAlCrY, CrAlY, CrAlSiY, TiAlSiY, Nitrid-PVD-Beschichtungen, die einen Anteil von einem oder mehreren Seltenerdenelementen enthalten, wie etwa TiAlCrYN, CrAlYN, CrAlSiYN, TiAlSiYN, und Mehrschicht-PVD-Beschichtungen, die zumindest ein Seltenerdenelement in einer der sich wiederholenden Schichten umfassen, wie etwa CrAlYN/CrN, TiAlYN/CrN, CrAlN/CrYN, umfasst.

4. Verfahren nach einem der vorhergehenden Ansprüche, wobei zumindest der Substratvorbehandlungsschritt unter Verwendung von Metallionenimplantation ausgeführt wird, bei welcher die Seltenerdenmetallionen durch eine Plasmaentladung erzeugt werden, die für die Erzeugung von Metallionen geeignet ist, oder wobei der Substratvorbehandlungsschritt unter Verwendung von Seltenerdenmetallionen ausgeführt wird, die durch eine Plasmaentladung erzeugt werden, wie etwa eine HIPIMS(Hochleistungsimpulsmagnetronsput-ter)- Entladung, eine Lichtbogenentladung und eine gefilterte Lichtbogenentladung, und wobei während des Substratvorbehandlungsschritts bevorzugt eine relativ hohe Vorspannung, z.B. eine Vorspannung im Bereich von -500 bis -1500 Volt, an das Substrat angelegt wird.

5. Verfahren nach einem der vorhergehenden Ansprüche, wobei die Substratbeschichtung in einem oder mehreren Schritten ausgeführt wird, die aus der Gruppe ausgewählt werden, die HIPIMS-Beschichtung, Lichtbogenverdampfungsbeschichtung und Magnetronsputtern umfasst.

6. Verfahren nach einem der vorhergehenden Ansprüche, wobei eine Oxiddeckbeschichtung oder eine Oxynitriddeckbeschichtung (wie etwa CrON) vorgesehen wird, wobei die Deckbeschichtung bevorzugt aus der Gruppe ausgewählt wird, die Aluminiumoxid, Chromoxid und Siliziumoxid umfasst und optional zumindest eines von Yttrium Y, Lanthan La oder Cäsium Ce oder Scandium Sc enthält.

7. Verfahren nach einem der vorhergehenden Ansprüche, wobei eine angrenzende Schicht an die Substratbasis oder Übergangsschicht verwendet wird, die eine stickstofffreie intermetallische Schicht ist, und/oder wobei eine angrenzende Schicht an die Substratbasis oder Übergangsschicht, die stickstofffrei ist, mit einer chemischen Zusammensetzung ähnlich/identisch wie die des Grundwerkstoffs verwendet wird.

8. Verfahren nach einem der vorhergehenden Ansprüche, wobei die Deckbeschichtung eine Nanobereichs-Mehrschichtstruktur oder eine Einzelschicht-Nanoverbundstruktur ist oder eine Vielzahl von übereinander gelegten Nanoverbundstrukturen umfasst.

9. Beschichtetes Substrat, das gemäß einem der obigen Verfahren gebildet ist und wobei die Konzentration von Seltenerdenatomen, die in der Grenzflächenschicht eingebettet sind, im Bereich von 0,1 - 10 % liegt und am stärksten bevorzugt im Bereich von 0,1 bis 1 % liegt.

10. Beschichtetes Substrat, das ein Metall oder eine Metalllegierung, wie etwa Schnellarbeitsstahl, eine Legierung auf TiAl-Basis oder eine Legierung auf Ni-Basis oder einen elektrisch leitenden Keramikwerkstoff umfasst, wobei das Substrat eine Grenzflächenschicht zu der Beschichtung aufweist, die durch gleichzeitige Bombardierung mit Ionen von mehr als einem Element erzeugt wird, die aber immer zumindest ein Seltenerdenelement umfasst, wodurch eine Implantation der Ionen in das Metall oder die Metalllegierung oder in den elektrisch leitenden Keramikwerkstoff resultiert, wobei die Konzentration der implantierten Elemente in das Substrat 50 Atom-% nicht übersteigt, und wobei die Konzentration von Seltenerdenatomen, die in der Grenzflächenschicht eingebettet sind, im Bereich von 0,1 - 10 % liegt und am stärksten bevorzugt im Bereich von 0,1-1% liegt.

11. Beschichtetes Substrat nach Anspruch 10, wobei die Beschichtung eine Hartstoffschutzbeschichtung umfasst, die aus der Gruppe ausgewählt ist, die intermetallische PVD-Beschichtungen, wie etwa TiAl, CrAl, AlSi, CrAlSi, Nitrid-PVD-Beschichtungen, wie etwa TiAlN, CrAlN, CrAlSiN, intermetallische PVD-Beschichtungen, die einen Anteil von einem oder mehreren Seltenerdenelementen enthalten, wie etwa TiAlCrY, CrAlY, CrAlSiY, Nitrid-PVD-Beschichtungen, die einen Anteil von einem oder mehreren Seltenerdenelementen enthalten, wie etwa TiAlCrYN, CrAlYN, CrAlSiYN, und Mehrschicht-PVD-Beschichtungen, die zumindest ein Seltenerdenelement in einer der sich wiederholenden Schichten umfassen, wie etwa CrAlYN/CrN, TiAlYN/CrN, CrAlN/CrYN, umfasst.

12. Beschichtetes Substrat nach Anspruch 10 oder Anspruch 11, wobei eine Oxiddeckbeschichtung oder eine Oxynitriddeckbeschichtung (wie etwa CrON) vorgesehen ist, wobei die Deckbeschichtung bevorzugt aus der Gruppe ausgewählt ist, die Aluminiumoxid, Chromoxid, Siliziumoxid umfasst und optional zumindest eines von Yttrium Y, Lanthan La oder Cäsium Ce oder Scandium Sc enthält.

13. Beschichtetes Substrat nach einem der Ansprüche 10 bis 12, wobei eine angrenzende Schicht an die Substratbasis oder Übergangsschicht verwendet wird, die eine stickstofffreie intermetallische Schicht ist und/oder wobei eine angrenzende Schicht an die Substratbasis oder Übergangsschicht, die stickstofffrei ist, mit einer chemischen Zusammensetzung ähnlich wie die des Grundwerkstoffs verwendet wird.

## Revendications

1. Procédé pour la fabrication d'un revêtement protecteur en matériau dur sur un substrat constitué d'un métal ou d'une matière céramique, par exemple un outil revêtu à utiliser dans une machine-outil, ou des composants exposés à haute température dans lequel, avant la déposition du revêtement protecteur en matériau dur, le substrat est prétraité par bombardement simultané avec des ions de plus d'un élément, mais incluant toujours au moins un élément de terres rares, avec ainsi pour résultat une implantation de ces ions dans ledit substrat pour former une couche interface, dans lequel la concentration des éléments implantés dans ledit substrat n'excède pas 50 at %, de préférence n'excède pas 20 at % et en particulier n'excède pas 10 at % et dans lequel la concentration des atomes de terres rares noyés dans ladite couche interface est dans la plage de 0,1 à 10 % et de façon plus préférée dans la plage de 0,1 à 1 %.

2. Procédé selon la revendication 1, dans lequel le matériau de terres rares est au moins un élément parmi yttrium Y, lanthane La ou césium Ce ou scandium Sc.

3. Procédé selon la revendication 1 ou 2, dans lequel le revêtement protecteur en matériau dur est choisi parmi le groupe comprenant des revêtements intermétalliques déposés en phase vapeur comme TiAl, CrAl, AlSi, CrAlSi, des revêtements de nitrure déposés en phase vapeur comme TiAIN, CrAlN, CrAISiN, des revêtements intermétalliques déposés en phase vapeur contenant une proportion d'un ou plusieurs éléments de terres rares comme TiAlCrY, CrAlY, CrAlSiY, TiAlSiY, des revêtements de nitrure déposés en phase vapeur contenant une proportion d'un ou plusieurs éléments de terres rares comme TiAlCrYN, CrAlYN, CrAlSiYN, TiAlSiYN, et des revêtements multicouches déposés en phase vapeur comprenant au moins un élément de terres rares dans l'une des couches répétitives, comme CrAlYN/CrN, TiAlYN/CrN, CrAlN/CrYN.

4. Procédé selon l'une quelconque des revendications précédentes, dans lequel l'étape de prétraitement du substrat au moins est effectuée en utilisant une implantation d'ions métalliques dans laquelle les ions métalliques de terres rares sont générés par une décharge au plasma qui convient pour la génération d'ions métalliques, ou dans lequel l'étape de prétraitement du substrat est effectuée en utilisant des ions métalliques de terres rares générés par une décharge au plasma comme une décharge HIPIMS (high power impulse magnetron sputtering ou "pulvérisation par magnétron avec impulsion de haute puissance"), une décharge d'un arc, et une décharge d'un arc filtré, et dans lequel une tension de polarisation relativement élevée est de préférence appliquée au substrat pendant l'étape de prétraitement du substrat, par exemple une tension de polarisation dans la plage de -500 à -1500 V.

5. Procédé selon l'une quelconque des revendications précédentes, dans lequel le revêtement du substrat est effectué en une ou plusieurs étapes choisies parmi le groupe comprenant revêtement HIPIMS, revêtement par vaporisation à l'arc, et pulvérisation par magnétron.

6. Procédé selon l'une quelconque des revendications précédentes, dans lequel un revêtement supérieur en oxyde ou un revêtement supérieur en oxyde nitrure (comme CrON) est prévu, le revêtement supérieur étant de préférence choisi parmi le groupe comprenant oxyde d'aluminium, oxyde de chrome et oxyde de silicium, et contenant en option au moins un élément parmi yttrium Y, lanthane La ou césium Ce ou scandium Sc.

7. Procédé selon l'une quelconque des revendications précédentes, dans lequel une couche adjacente à la base du substrat ou couche de transition est utilisée qui est une couche intermétallique dépourvue d'azote et/ou dans lequel une couche adjacente à la base du substrat ou couche de transition est utilisée qui est exempte d'azote avec une composition chimique similaire/identique à celle du matériau de base.

8. Procédé selon l'une quelconque des revendications précédentes, dans lequel le revêtement supérieur est une nanostructure multicouche ou une nanostructure composite monocouche, ou comprend une pluralité de nanostructures composites superposées.

9. Substrat revêtu formé en accord avec la quelconque des procédés ci-dessus, et dans lequel la concentration des atomes de terres rares noyés dans ladite couche interface est dans la plage de 0,1 à 10 %, et de façon plus préférée dans la plage de 0,1 à 1 %.

10. Substrat revêtu comprenant un métal ou un alliage de métal comme un acier rapide, un alliage à base de TiAl ou un alliage à base de Ni, ou un matériau céramique électriquement conducteur, le substrat ayant une couche interface vers le revêtement produit par bombardement simultané avec des ions de plus d'un élément, mais incluant toujours au moins un élément de terres rares, avec pour résultat l'implantation de ces ions dans ledit métal ou ledit alliage métallique ou dans le matériau céramique électriquement conducteur, dans lequel la concentration des éléments implantés dans ledit substrat n'excède pas 50 at %, et dans lequel la concentration des atomes de terres rares noyés dans ladite couche interface est dans la plage de 0,1 à 10 %, et de façon plus préférée dans la plage de 0,1 à 1 %.

11. Substrat revêtu selon la revendication 10, dans lequel le revêtement comprend un revêtement protecteur en matériau dur choisi parmi le groupe comprenant des revêtements intermétalliques déposés en phase vapeur comme TiAl, CrAl, AlSi, CrAlSi, des revêtements de nitrure déposés en phase vapeur comme TiAIN, CrAlN, CrAISiN, des revêtements intermétalliques déposés en phase vapeur contenant une proportion d'un ou plusieurs éléments de terres rares comme TiAlCrY, CrAlY, CrAlSiY, TiAlSiY, des revêtements de nitrure déposés en phase vapeur contenant une proportion d'un ou plusieurs éléments de terres rares comme TiAlCrYN, CrAlYN, CrAlSiYN, TiAlSiYN, et des revêtements multicouches déposés en phase vapeur comprenant au moins un élément de terres rares dans l'une des couches répétitives, comme CrAlYN/CrN, TiAlYN/CrN, CrAlN/CrYN.

12. Substrat revêtu selon la revendication 10 ou 11, dans lequel un revêtement supérieur d'oxyde ou un revêtement supérieur en oxyde nitrure (comme CrON) est prévu, le revêtement supérieur étant de préférence choisi parmi le groupe comprenant oxyde d'aluminium, oxyde de chrome et oxyde de silicium, et contenant en option au moins un élément parmi yttrium Y, lanthane La ou césium Ce ou scandium Sc.

13. Substrat revêtu selon l'une quelconque des revendications 10 à 12, dans lequel une couche adjacente à la base du substrat ou couche transition est utilisée, qui est une couche intermétallique dépourvue d'azote et/ou dans lequel une couche adjacente à la base du substrat ou couche de transition est utilisée qui est exempte d'azote avec une composition chimique similaire à celle du matériau de base.
